# EUROPÄISCHE PATENTSCHRIFT

(11) **EP 2 387 155 B1**
(45) Veröffentlichungstag und Bekanntmachung des Hinweises auf die Patenterteilung: **10.10.2018**
(21) Anmeldenummer: 11162075.3
(22) Anmeldetag: 12.04.2011
(51) Int. Cl.: H03K 17/691, H03K 17/18

(54) **Verfahren zur Übertragung eines binären Signals über eine Übertragerstrecke**
Method for transmitting a binary signal over a transmission path
Procédé de transmission d'un signal binaire via une trajectoire de transmetteur

(30) Priorität: 10.05.2010 DE 102010028817
(43) Veröffentlichungstag der Anmeldung: 16.11.2011
(73) Patentinhaber: SEMIKRON Elektronik GmbH & Co. KG, 90431 Nürnberg (DE)
(72) Erfinder: Königsmann, Gunter, 91058, Erlangen (DE); Mühlhöfer, Alexander, 90522, Oberasbach (DE); Hofmair, Markus, 91154, Roth (DE); Obernöder, Daniel, 97346, Iphofen (DE)

(56) Entgegenhaltungen:
- DE-T2- 69 129 179
- US-A1- 2004 080 885
- US-A1- 2009 147 544

## Beschreibung

Verfahren zur Übertragung eines binären Signals über eine Übertragerstrecke.

Die Erfindung betrifft ein Verfahren zur repetitiven Übertragung eines einen binären Wert repräsentierenden Signals über eine Übertragerstrecke eines Treibers eines Leistungshalbleiters.

Zur Ansteuerung eines Leistungshalbleiters, z.B. eines Leistungshalbleiterschalters in Form eines IGBT (insulated-gate bipolar transistor), ist eine sogenannten Treiberschaltung oder kurz ein Treiber notwendig. Z.B. erzeugt der Treiber aus einem dem Treiber am Eingang zugeführten logischen Schaltsignal schwacher Leistung ein am Ausgang des Treibers an den Leistungshalbleiter anzulegendes Signal mit deutlich erhöhter Leistung, welche beispielsweise zum tatsächlichen Schalten eines IGBT notwendig ist. Außerdem übernimmt der Treiber eine galvanische bzw. Potentialtrennung zwischen seinem Eingang und Ausgang, z.B. dem Schaltsignal bzw. einer auf Erdpotential arbeitenden Ansteuerlogik und dem Leistungshalbleiter, welcher auf Hochspannungspotential arbeitet.

In der Regel wird innerhalb dieses Treibers daher ein binäres Signal, d.h. ein Signal, das einen binären Wert repräsentiert, über eine Übertragerstrecke des Treibers übertragen. Der Übertrager bewirkt die Potentialtrennung im zu übertragenenden Signal. Ein entsprechendes binäres Signal ist z.B. ein Einschalt- bzw. Ausschaltsignal für den Übertrager. Ein Signal in Form eines Schaltsignals kennt z.B. nur die beiden Signalwerte "Ein" und "Aus". Um eine hohe Schaltsicherheit zu erzielen, ist es üblich, entsprechende Signale bzw. Signalwerte repetitiv zu übertragen. Bekannt ist es z.B., beim Anlegen eines Einschaltsignals dem Übertrager als ersten binären Wert - z.B. ausgehend von einem Mittenpotential - repetitiv positive Spannungsimpulse zuzuführen. Diese Impulse werden dem Übertrager so lange zugeführt, bis ein Ausschalten des Leistungshalbleiters gewünscht ist. Ausgehend vom Mittenpotenzial werden daraufhin dem Übertrager repetitiv negative Spannungspulse zugeführt.

Sowohl während Anliegen des Einschalt- als auch des Ausschaltsignals gelangt der Übertrager bzw. dessen Magnetisierung durch repetitives Anlegen der jeweiligen gleichen positiven oder negativen Spannungspulse in eine positive oder negative Sättigung. Um eine Sättigung des Übertragers zu vermeiden, ist es bekannt, die Zeit zwischen zwei gleichen aufeinanderfolgenden repetitiv angelegten Impulsen als Erholungszeit für den Übertrager zu nutzen, damit sich dieser zumindest teilweise wieder entmagnetisieren kann. Es ist also eine Mindestzeit bzw. minimale Totzeit zwischen zwei gleichen repetitiven Pulsen einzuhalten.

Aus der US 2009/0147544 A1 ist ein Treiber zur Ansteuerung eines Halbleiterschalters bekannt, wobei ein moduliertes Ansteuersignal zur Ansteuerung des Halbleiterschalters über einen Transformator von einer Primärseite des Treibers auf eine Sekundärseite des Treibers übertragen wird und auf der Sekundärseite des Treibers wieder demoduliert wird.

Aus der US 2004/0080885 A1 ist eine Antriebssteuerung für einen elektrischen Antrieb mit einem Leistungsteil bekannt, das auf einem hohen elektrischen Potential liegt, wobei die Antriebssteuerung eine Ansteuerelektronik, die dem Leistungsteil Ansteuersignale liefert und von diesem Phasenstromistwerte erhält und eine Regelungseinheit, die auf einem niedrigen elektrischen Potential liegt und mit der Ansteuerelektronik über eine digitale Kommunikationsschnittstelle verbunden ist, aufweist, wobei zwischen dem Leistungsteil und der Regelungseinheit eine galvanische Trennung besteht, wobei zur galvanischen Trennung ausschließlich ein geeigneter elektrischer Übertrager in die Kommunikationsschnittstelle zwischen der Regelungseinheit und der Ansteuerelektronik geschaltet ist.

Aus der DE 691 29 179 T2 ist eine Schaltsteuerschaltung zur Ansteuerung eines Transistors bekannt, bei der der Transistor über einen Impulstransformator der Schaltsteuerschaltung mittels Impulsen, welche über den Impulstransformator an eine Schwellenschaltung der Schaltsteuerschaltung übermittelt werden, ein- oder ausgeschaltet wird.

Aufgabe der Erfindung ist es, ein verbessertes Verfahren zur repetitiven Übertragung eines einen binären Wert repräsentierenden Signals über eine Übertragerstrecke eines Treibers eines Leistungshalbleiters anzugeben.

Die Aufgabe wird gelöst durch ein Verfahren gemäß Patentanspruch 1.

Erfindungsgemäß wird dem Eingang des Übertragers für den ersten der binären Werte des Signals ein erstes Impulspaket als Folge eines positiven und negativen Impulses - ausgehend von einer Mittensignallage - zugeführt. Alternativ wird dem Übertrager für den zweiten Wert des binären Signals ein zweites Impulspaket als Folge eines negativen und positiven Impulses zugeführt. Ein Impuls kann hierbei z.B. ein Strom- oder Spannungspuls sein. Dem Überträger wird also z.B. ausgehend von einer Mittenspannung eine Folge eines positiven und negativen Spannungspulses bzw. Spannung oder einer negativ-positiv-Folge. Auch kann z.B. ausgehend von einem Nullstrom ein kurzer positiver, gefolgt von einem negativen Strompuls oder umgekehrt, zugeführt werden.

Die jeweiligen gleichen Pakete werden dem Übertrager repetitiv zugeführt. Am Ausgang des Übertrager wird sodann die Polarität einer Ausgangsgröße überwacht bzw. Ausgewertet: Die Ausgangsgröße kann hierbei wieder z.B. eine Ausgangsspannung oder ein Ausgangsstrom des Übertragers sein. Die Auswertung erfolgt jedoch nun nicht alleine aus einem der beiden Pulse, sondern aus deren Gesamtheit bzw. dem gesamten Signalverlauf innerhalb der Impulsfolge. Erst aus der Folge der Polarität bzw. dem Polaritätswechsel der Ausgangsgröße innerhalb eines übertragenen Paketes wird also der erste oder zweite Wert des binären Signals detektiert. Bedingung ist hierfür lediglich, dass die Paketgrenzen am Ausgang des Übertragers erkennbar sein müssen, z.B. durch die Einhaltung bestimmter gesetzter Timinggrenzen.

Dadurch, dass in jedem Impulspaket jeweils sowohl ein positiver als auch ein negativer Impuls vorhanden ist, kann verhindert werden, dass der Übertrager in Sättigung geht. Hierzu werden beispielsweise die positiven und negativen Impulse bezüglich ihrer beinhaltenden Energie aneinander angepasst, z.B. so, dass sich deren Magnetisierungswirkung im Übertrager zumindest annähernd kompensiert. Da der Übertrager durch das jeweilige Impulspaket nicht in Sättigung geht, müssen insbesondere nicht die o.g. Zwangspausen bzw. Totzeiten zwischen zwei repetitiven Impulspaketen des gleichen binären Wertes eingehalten werden. Die Impulspakete können also - unter Einhaltung der oben genannten Bedingungen zur Erkennung der Paketgrenzen - nahezu beliebig schnell, insbesondere mit beliebigem Zeitabstand, aufeinander folgen.

Die Übertragerstrecke in einem Treiber kann hierbei sowohl von der Primär- zur Sekundärseite als auch in umgekehrter Richtung liegen. Vorrausetzung für das erfindungsgemäße Verfahren ist lediglich, dass der Signalempfänger, d.h. die ausgangsseitig am Übertrager angeschlossene Auswerteschaltung sowohl positive als auch negative Ausgangssignale des Übertragers auswerten kann.

Das erste Signal kann z.B. ein von der Primär- zur Sekundärseite zu übertragendes Schaltsignal oder ein in Gegenrichtung zu übertragendes Fehlersignal sein.

In einer bevorzugten Ausführungsform sind die jeweiligen Amplituden der Impulse innerhalb der Impulspakete zumindest annähernd gleich groß. Mit anderen Worten besteht ein Impulspaket aus z.B. zwei gleichhohen Impulsen entgegengesetzten Vorzeichens. Ist dann auch deren Dauer gleich, wird wieder entsprechend zu oben der Energieinhalt der Pulse gleich.

Bei dem Verfahren ist das binäre Signal ein erstes Signal und am Eingang des Übertragers wird der Zeitabstand zwischen zwei repetitiv aufeinanderfolgenden Impulspaketen desselben Wertes des ersten Signals in Abhängigkeit von einem zweiten zu übertragenden Signal variiert. Am Ausgang wird dann der Zeitabstand aus den detektierten, in der Ausgangsgröße abgebildeten Impulspaketen ermittelt und das zweite Signal aus dem ausgangsseitig ermittelten Zeitabstand rekonstruiert.

Da wie erwähnt gemäß der Erfindung keine Mindesttotzeiten zwischen zwei Impulspaketen einzuhalten sind und die Zeitabstände in einem weiten Rahmen variiert werden können, kann also dem eigentlichen zu übertragenden ersten binären Signal ein zweites Signal überlagert werden. Auch das zweite Signal kann hierbei z.B. ein binäres Signal sein, welches lediglich zwei Werte und damit zwei Zeitabstände zwischen aufeinanderfolgenden Impulspaketen kennt. Hier sind jedoch je nach Auswertelogik auf der Ausgangsseite auch mehrere Werte oder ein kontinuierliches Signal als zweites Signal denkbar, d.h. es existieren mehrere verschiedene oder kontinuierlich variierende Zeitabstände zwischen Impulspaketen.

Zu beachten ist lediglich, dass ein Wertewechsel des ersten Signals in der Regel zu einem beliebigen Zeitpunkt erfolgen kann, so dass der Zeitabstand zwischen einem letzten Impulspaket des einen binären Wertes des ersten Signals und dem ersten Impulspaket des anderen binären Wertes nicht als gültiges zweites Signal erkannt werden darf. Mit anderen Worten zerstört ein Wertewechsel im ersten Signal an dieser Stelle in der Regel den Wert des zweiten Signals.

Das zweite Signal kann z.B. der Wert einer Zwischenkreisspannung oder ein Soft-Off-Schaltsignal sein.

In einer weiteren Ausführungsform des Verfahrens wird alternativ oder zusätzlich am Eingang die Pulsdauer des Impulses in Anhängigkeit von einem Dritten zu übertragenden Signal variiert. Am Ausgang wird dann die Impulsdauer des Impulses ermittelt und das dritte Signal aus der Impulsdauer rekonstruiert. Somit kann in ein- und demselben Signal noch eine weitere Zusatzinformation in Form des dritten Signals übertragen werden, welches ebenso wie das zweite Signal binär, mehrwertig oder kontinuierlich sein kann. Je nach Bedingungen für die Signalerzeugung am Übertragereingang kann auch sichergestellt werden, dass der Wechsel des ersten binären Signales nur außerhalb der Dauer von Impulspaketen erlaubt ist bzw. übertragen wird. Erstes und drittes Signal würde sich so z.B. nicht gegenseitig stören. In der Regel wird jedoch der Vorrang des ersten Signals wünschenswert sein, wenn dieses z.B. ein Schaltsignal für einen Leistungshalbleiterschalter ist, das zweite und dritte Signal jedoch z.B. weniger kritische zu übertragende Daten repräsentieren.

Das dritte Signal kann z.B. den Wert einer gemessenen Temperatur repräsentieren.

Sämtliche drei oben genannten Möglichkeiten zur Signalübertragung vom ersten bis dritten Signal können damit unabhängig voneinander oder zusammen in entsprechenden Kombinationen, sowohl von der Primär- zur Sekundärseite also auch umgekehrt, verwendet werden. Die Übertragung der Signale erfolgt immer parallel in der gleichen Richtung.

Für eine weitere Beschreibung der Erfindung wird auf die Ausführungsbeispiele der Zeichnungen verwiesen. Es zeigen, jeweils in einer schematischen Prinzipskizze:
- Fig.1: einen Treiber eines Leistungshalbleiterschalters,
- Fig.2: Signalverläufe im Treiber aus Fig.1 für die Übertragung eines ersten binärwertigen Signals,
- Fig.3: die Signalverläufe aus Fig.2 im Detail,
- Fig.4: Signalverläufe im Treiber für ein zweites zu übertragendes Signal,
- Fig.5: alternative Signalverläufe im Treiber für ein drittes zu übertragendes Signal.

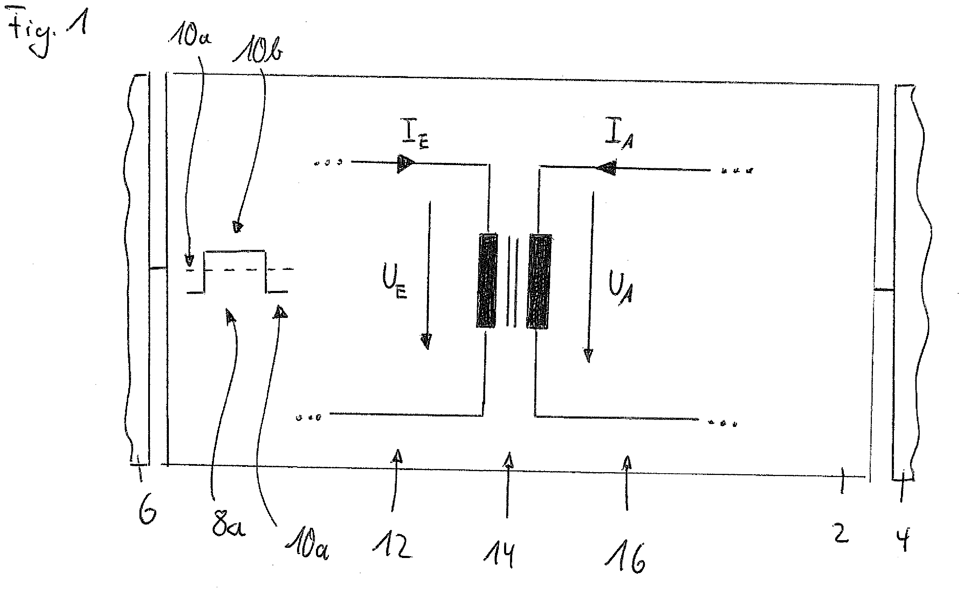

Fig. 1 zeigt einen Treiber 2 für einen Leistungshalbleiter 4, der von einer Logikschaltung 6 mit einem Signal 8 als Schaltsignal für die Schaltzustände "Ein" oder "Aus" des Leistungshalbleiters 4 versorgt wird. Das Signal 8 ist also ein binäres Signal bzw. verfügt nur über zwei Werte 10a entsprechend "Aus" und 10b entsprechend "Ein". Das Signal 8 wird auf einen Eingang 12 eines Übertragers 14 gegeben, der die galvanisch trennende Übertragung des Signals 8 zum Ausgang 16 bewirkt. Der Übertrager 14 besitzt an seinem Eingang 12 als Eingangsgrößen einen Eingangsstrom I_{E} sowie eine Eingangsspannung UE und an seinem Ausgang als Ausgangsgrößen einen Ausgangsstrom I_{A} und eine Ausgangsspannung U_{A}.

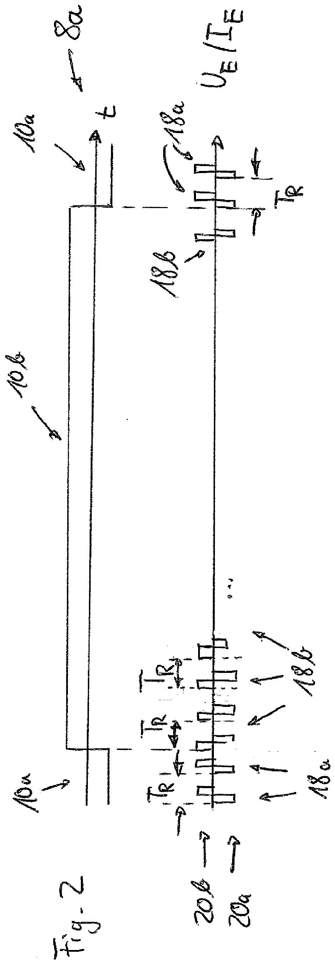

Fig. 2 zeigt nochmals das Signal 8 in vergrößerter Darstellung, aufgetragen über der Zeit t. Erfindungsgemäß werden nun, um das Signal 8 zu repräsentieren, dem Übertrager 14 repretetiv jeweils Impulspakete 18a,b zugeführt. Für den Wert 10a werden Impulspakete 18a gewählt, für den Wert 10b Impulspakete 18b. Die Impulspakete 18a bestehen jeweils aus einer Folge eines negativen Impulses 20a gefolgt von einem positiven Impuls 20b, die positiven Impulspakete 18b hingegen von einem positiven Impuls 20b, gefolgt von einem negativen Impuls 20a. Die jeweiligen Pakete 18a oder 18b werden jeweils repetitiv gesendet, d.h. in einem zeitlichen Abstand T_{R}. Da der Wechsel des Wertes 10a zum Wert 10b bzw. 10b zum Wert 10a im Signal 8 zu einem beliebigen Zeitpunkt erfolgen kann, liegen zwischen dem jeweiligen letzten Impulspaket 18a und dem ersten Impulspaket 10b bzw. dem letzten Impulspaket 18b und dem ersten Impulspaket 18a jeweils zeitliche Abstände, die kleiner oder gleich dem Abstand T_{R} sind.

Der jeweilige Impuls 20a bzw. 20b entspricht in Fig. 1 einem jeweils positiven oder negativen Wert des Stromes I_{E} oder alternativ einem positiven oder negativen Wert der Spannung U_{E}.

Am Ausgang 16 des Übertragers 14 stellen sich entsprechende Signalverläufe für die Ausgangsspannung U_{A} bzw. den Ausgangsstrom I_{A} ein. Aus der jeweiligen Folge der Polarität der Impulspakete 18a oder 18b ergeben sich auch unterschiedliche Polaritätsfolgen für den Ausgangsstrom I_{A} oder die Ausgangsspannung U_{A}.

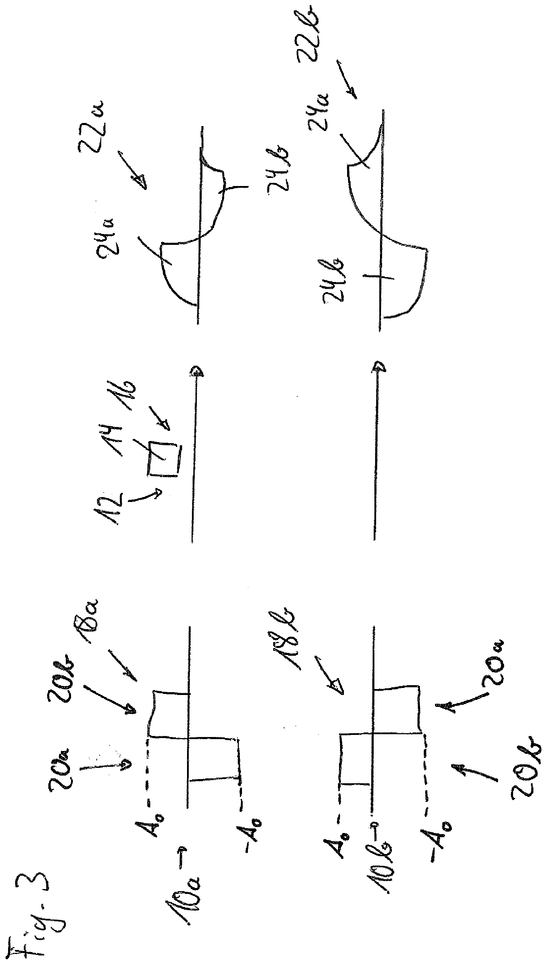

Fig.3 zeigt beispielsweise, wie sich so für das Impulspaket 18a eine Folge 22a eines zunächst positiven und später negativen Impulses 24a,b ergibt.

Wird dagegen am Eingang 12 ein Impulspaket 18b angelegt, ergibt sich eine Folge 22b eines negativen Impulses 24b und eines positiven Impulses 24a. Gemäß der Polaritätsfolge der Folgen 22a,b wird auf der Seite des Ausgangs 16 auf die entsprechende Impulsfolge am Eingang 12 und damit auf den entsprechenden Wert 10a,b des Signals 8 geschlossen.

Die Detektion erfolgt jeweils anhand der Gesamtheit der Folgen 22a,b, also auch anhand des gesamten Impulspaketes 18a,b, und nicht nur anhand desjenigen Teils (Impulse 24a oder 24b) der Folgen 22a,b, die einem einzelnen Impuls 20a oder 20b zuzuordnen sind. So kann die Auswertung z.B. anhand des Flankenverlaufs (positiver oder negativer Nulldurchgang) zwischen den jeweiligen Impulsen 24a,b, also jeweils etwa mittig in der Folge 22a,b erfolgen.

Fig.3 zeigt außerdem eine Ausführungsform, bei der die Amplituden A₀ und -A₀ der beiden Impulse 20a,b der Impulspakete 18a,b vom Betrag her gleich sind (Ao), aber entgegengesetztes Vorzeichen aufweisen. Hier bietet sich auch die Möglichkeit an, die gesamten beiden Impulse 24a,b, auch im Hinblick auf ihre Amplituden hin, in ihrer Gesamtheit auszuwerten. Beide Amplituden sollten dann wieder etwa gleich groß sein und entgegengesetztes Vorzeichen aufweisen. Auch so erfolgt eine Auswertung der gesamten Impulsfolge 18a,b und nicht nur deren Teilimpulse 20a,b hinsichtlich der Detektion der zu übertragenden Binärwerte (erster oder zweiter Wert).

In der oben genannten ersten Ausführungsform sind die jeweiligen Zeitabstände T_{R} stets gleich groß gewählt, die repetitive Wiederholung jeweils gleicher Impulspakete 18a,b erfolgt also mit fester Wiederholfrequenz.

Bei dem Verfahrens wird durch die Verwendung verschiedener bzw. signalabhängig variierender Zeitabstände T_{R} ein zweites Signal 8b über den Übertrager 14 parallel zum ersten Signal 8a übertragen.

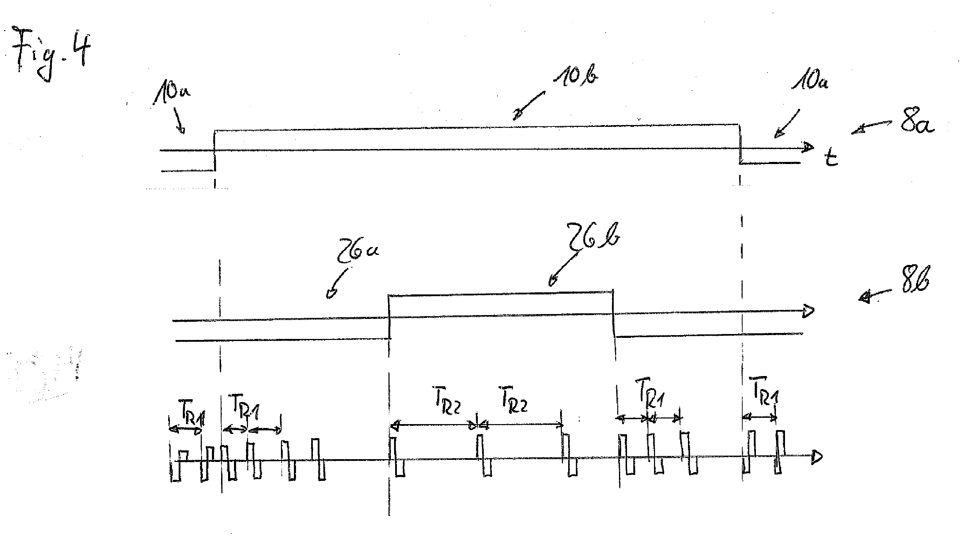

Fig. 4 zeigt, dass zusätzlich zum Signal 8a noch das Signal 8b übertragen wird. Auch dieses besitzt im Beispiel lediglich zwei Werte 26a,b. Die Werte 26a,b werden in unterschiedliche Abstände T_{R} umgesetzt. Die Zeitabstände T_{R1} entsprechen hierbei dem Wert 26a, die Zeitabstände T_{R2} dem Wert 26b. Die entsprechenden Zeitabstände T_{R1,2} werden wieder wie gemäß Fig. 3 am Ausgang 16 ebenfalls als Zeitabstände zwischen zwei Folgen 22a,b ausgewertet bzw. erkannt und hierdurch die Werte 26a,b rekonstruiert.

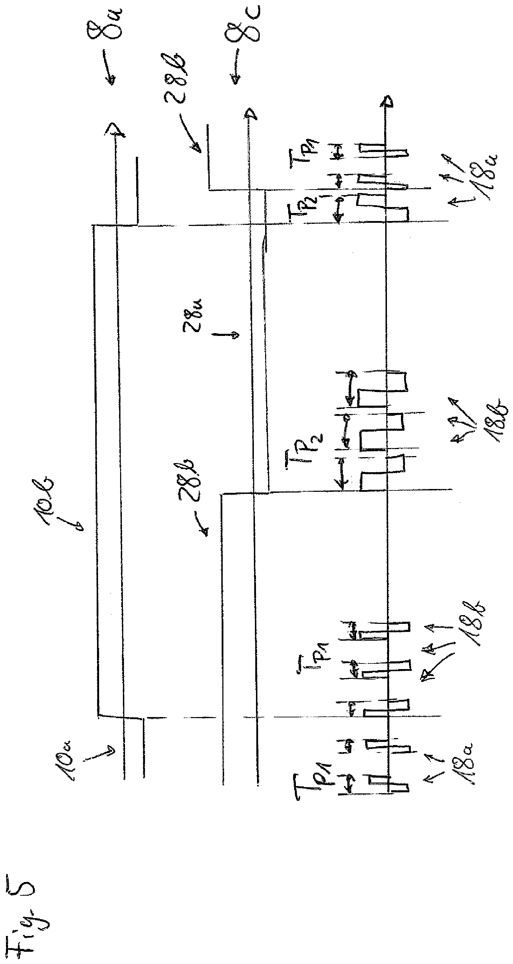

Fig. 5 zeigt eine alternative Ausführungsform zur Darstellung eines dritten Signals 8c und dessen Übertragung über den Übertrager 14. Das Signal 8a wird in herkömmlicher Weise kodiert, die Werte 28a,b des Signals 8c werden jedoch durch unterschiedliche Pulsdauern T_{P1,2} der einzelnen Pulse 18a,b kodiert. Die Auswertung am Ausgang 16 erfolgt wieder gemäß der Unterscheidung der Pulsdauern der Impulse 24a,b bzw. der Folgen 22a,b entsprechend zu Fig. 3.

### Bezugszeichenliste

2 Treiber
4 Leistungshalbleiter
6 Logikschaltung
8a-c Signal
10a,b Wert
12 Eingang
14 Übertrager
16 Ausgang
18a,b Impulspaket
20a,b Impuls
22a,b Folge
24a,b Impuls
26a,b Wert
28a,b Wert
I_{E,A} Strom
U_{E,A} Spannung
t Zeit
T_{R1,2} Abstand
T_{P1,2} Pulsdauer
A₀ Amplitude

## Patentansprüche

1. Verfahren zur repetitiven Übertragung eines einen binären Wert (10a,b) repräsentierenden ersten Signals (8a) und eines zweiten Signals (8b) über eine Übertragerstrecke eines Treibers (2) eines Leistungshalbleiters (4), bei dem:
- einem Eingang (12) eines Übertragers (14) der Übertragerstrecke für den ersten Wert (10a) des ersten Signals (8a) ein erstes Impulspaket (18a) realisiert als Folge eines positiven (20b) und negativen Impulses (20a) und für den zweiten Wert (10b) des ersten Signals (8a) ein zweites Impulspaket (18b) realisiert als Folge eines negativen (20a) und positiven Impulses (20b) zugeführt wird,
- die jeweiligen Impulspakete (18a,b) dem Übertrager (14) repetitiv zugeführt werden,
- an einem Ausgang (16) des Übertragers (14) aus der Folge (22a,b) der Polarität einer Ausgangsgröße (U_{A},I_{A}) innerhalb eines übertragenen Impulspaketes (18a,b) der erste (10a) oder zweite Wert (10b) des ersten Signals detektiert wird,
- am Eingang (12) der Zeitabstand (T_{R}) zwischen zwei repetitiv aufeinanderfolgenden gleichen Impulspaketen (18a,b) in Abhängigkeit vom zweiten zu übertragenden Signal (8b) variiert wird,
- am Ausgang (16) der Zeitabstand (T_{R}) aus den in der Ausgangsgröße (U_{A},I_{A}) abgebildeten Impulspaketen (18a,b) ermittelt wird,
- das zweite Signal (8b) aus dem Zeitabstand (T_{R}) rekonstruiert wird.

2. Verfahren nach Anspruch 1, bei dem die jeweiligen Amplituden der beiden Impulse (20a,b) innerhalb des Impulspaketes (18a,b) zumindest annähernd gleich groß sind.

3. Verfahren nach einem der vorhergehenden Ansprüche, bei dem:
- am Eingang (12) die Pulsdauer (T_{P1,2}) des Impulses (20a,b) in Abhängigkeit von einem dritten zu übertragenden Signal (8c) variiert wird,
- am Ausgang (16) die Pulsdauer (T_{P1,2}) des Impulses (20a,b) aus den in der Ausgangsgröße (U_{A},I_{A}) abgebildeten Impulspaketen (18a,b) ermittelt wird,
- das dritte Signal (8c) aus der Pulsdauer (T_{P1,2}) rekonstruiert wird.

## Claims

1. Method for the repetitive transmission of a first signal (8a) representing a binary value (10a, b) and of a second signal (8b) via a transformer section of a driver (2) of a power semiconductor (4) wherein:
- for the first value (10a) of the first signal (8a) a first pulse packet (18a) realized as a sequence of a positive pulse (20b) and a negative pulse (20a) and for the second value (10b) of the first signal (8a) a second pulse packet (18b) realized as a sequence of a negative pulse (20a) and a positive pulse (20b) is fed to an input (12) of a transformer (14),
- the respective pulse packets (18a, b) are fed to the transformer (14) repetitively,
- the first value (10a) or second value (10b) of the first signal is detected at an output (16) of the transformer (14) from the sequence (22a, b) of the polarity of an output variable (U_{A}, I_{A}) within a transmitted pulse packet (18a, b),
- at the input (12) the time interval (T_{R}) between two repetitively successive identical pulse packets (18a, b) is varied in a manner dependent on the second signal (8b) to be transmitted,
- at the output (16) the time interval (T_{R}) is determined from the pulse packets (18a, b) mapped in the output variable (U_{A}, I_{A}),
- the second signal (8b) is reconstructed from the time interval (T_{R}).

2. Method according to Claim 1, wherein the respective amplitudes of the two pulses (20a, b) within the pulse packet (18a, b) are at least approximately equal in magnitude.

3. Method according to any of the preceding claims, wherein:
- at the input (12) the pulse duration (T_{P1,2}) of the pulse (20a, b) is varied in a manner dependent on a third signal (8c) to be transmitted,
- at the output (16) the pulse duration (T_{P1,2}) of the pulse (20a, b) is determined from the pulse packets (18a, b) mapped in the output variable (U_{A}, I_{A}),
- the third signal (8c) is reconstructed from the pulse duration (T_{P1,2}).

## Revendications

1. Procédé de transmission répétitive d'un premier signal (8a) représentant une valeur binaire (10a,b) et d'un deuxième signal (8b) via une trajectoire de transmetteur d'un driver (2) d'un semiconducteur de puissance (4), dans lequel :
- à une entrée (12) d'un transmetteur (14) de la trajectoire de transmetteur, sont acheminés, pour la première valeur (10a) du premier signal (8a), un premier paquet d'impulsions (18a) réalisé en tant que succession d'une impulsion positive (20b) et d'une impulsion négative (20a), et pour la deuxième valeur (10b) du premier signal (8a), un deuxième paquet d'impulsions (18b) réalisé en tant que succession d'une impulsion négative (20a) et d'une impulsion positive (20b),
- les paquets d'impulsion respectifs (18a,b) sont acheminés de manière répétitive au transmetteur (14),
- à une sortie (16) du transmetteur (14), à partir de la succession (22a,b) de la polarité d'une grandeur de sortie (U_{A}, I_{A}) à l'intérieur d'un paquet d'impulsions transmis (18a,b), on détecte la première (10a) ou la deuxième (10b) valeur du premier signal,
- à l'entrée (12), l'intervalle de temps (T_{R}) entre deux paquets d'impulsions identiques successifs (18a,b) est varié en fonction du deuxième signal (8b) à transmettre,
- à la sortie (16), l'intervalle de temps (T_{R}) est déterminé à partir des paquets d'impulsions (18a,b) reproduits dans la grandeur de sortie (U_{A},I_{A}),
- le deuxième signal (8b) est reconstruit à partir de l'intervalle de temps (T_{R}).

2. Procédé selon la revendication 1, dans lequel les amplitudes respectives des deux impulsions (20a,b) à l'intérieur du paquet d'impulsions (18a,b) sont au moins approximativement identiques.

3. Procédé selon l'une quelconque des revendications précédentes, dans lequel :
- à l'entrée (12) la durée d'impulsion (T_{P1,2}) de l'impulsion (20a,b) est variée en fonction d'un troisième signal (8c) à transmettre,
- à la sortie (16), la durée d'impulsion (T_{P1,2}) de l'impulsion (20a,b) est déterminée à partir des paquets d'impulsions (18a,b) reproduits dans la grandeur de sortie (U_{A},I_{A}),
- le troisième signal (8c) est reconstruit à partir de la durée d'impulsion (T_{P1,2}).
